# EUROPÄISCHE PATENTANMELDUNG

(11) **EP 4 340 550 A1**
(43) Veröffentlichungstag der Anmeldung: **20.03.2024**
(21) Anmeldenummer: 23194657.5
(22) Anmeldetag: 31.08.2023
(51) Int. Cl.: H05K 1/02, H05K 3/00, H05K 1/03, H05K 1/11, H05K 1/14, H05K 3/34

(54) **ELEKTRISCHES MODUL UND LEITERPLATTENANORDNUNG MIT EINEM ELEKTRISCHEN MODUL**

(30) Priorität: 15.09.2022 DE 102022123589
(71) Anmelder: Rolls-Royce Deutschland Ltd & Co KG, 15827 Blankenfelde-Mahlow (DE)
(72) Erfinder: BHARATH, Subhashini, 15827 Blankenfelde-Mahlow (DE); SCHAMBERGER, Niklas, 15827 Blankenfelde-Mahlow (DE); BUCHERT, Stanley, 15827 Blankenfelde-Mahlow (DE); WALTRICH, Uwe, 15827 Blankenfelde-Mahlow (DE); PATEL, Dipenkumar, 15827 Blankenfelde-Mahlow (DE)

(57) **Zusammenfassung**

Die Erfindung betrifft ein elektrisches Modul, das aufweist: eine Oberseite (21) und eine Unterseite (22), wobei die Oberseite (21) vier rechteckig angeordnete Seitenkanten (211-214) aufweist, ein in das elektrische Modul (2) eingebettetes elektrisches Bauelement (24), und mindestens drei an der Oberseite (21) ausgebildete elektrische Lotpads (6, 61-63, 7, 71-74, 8), die einer elektrischen Kontaktierung des elektrischen Bauelements (24) dienen und die dazu ausgebildet und vorgesehen sind, jeweils über eine Lotschicht (16, 17, 18) mit einem zugeordneten elektrischen Lotpad (41, 42, 43) einer Leiterplatte (1) in Kontakt zu treten. Es ist vorgesehen, dass die Lotpads (6, 61-63, 7, 71-72, 8) des elektrischen Moduls (2) in symmetrischer Anordnung auf der Oberseite (21) des elektrischen Moduls (2) angeordnet sind, wobei die Lotpads (6, 7, 71-72, 8) achsensymmetrisch an der Oberseite (21) des elektrischen Moduls (2) angeordnet sind und/oder sämtliche Lotpads (6, 61-63, 7, 73-74, 8) sich entlang zweier gegenüberliegender Seitenkanten (212, 214) an der Oberseite (21) des elektrischen Moduls (2) erstrecken. Die Erfindung betrifft des Weiteren eine Leiterplattenanordnung mit einem solchen elektrischen Modul.

## Beschreibung

Die Erfindung betrifft ein elektrisches Modul gemäß dem Oberbegriff des Patentanspruchs 1 und eine Leiterplattenanordnung mit einem elektrischen Modul.

Es sind elektrische Module bekannt, die ein eingebettetes Halbleiterbauelement aufweisen und an ihrer Außenseite elektrische Kontakte zur Kontaktierung des Halbleiterbauelements ausbilden. Beispielsweise sind elektrische Module bekannt, bei denen ein eingebettetes Halbleiterbauelement auf einem keramischen Schaltungsträger angeordnet ist, der eine Metallisierungsschicht auf HochvoltPotential auf einer isolierenden Keramikschicht ausbildet und direkt oder über weitere Schichten mit einem Kühlkörper gekoppelt ist. Der keramische Schaltungsträger bildet dabei zusammen mit dem Halbleiterbauelement und einer Umhüllung z.B. aus Vergussmaterial ein elektrisches Modul, das über an seiner Oberfläche ausgebildete Kontakte mit einer Trägerplatine bzw. Leiterplatte verbindbar ist. Solche elektrischen Module werden auch als Prepackage-Module bezeichnet.

Die Anordnung solcher Prepackage-Module an einer Trägerplatine erfolgt über einen Lötprozess, bei dem einander zugeordnete Lotpads auf dem Prepackage-Modul und auf der Leiterplatte über eine Lotschicht miteinander verbunden werden. Dabei entsteht prinzipbedingt ein Luftspalt zwischen dem Prepackage-Modul und der Leiterplatte. Dabei bestimmt die Lotschichtdicke die Höhe des Luftspalts. Da der Lötprozess Flussmittel benötigt, verbleiben nach dem Lötprozess Flussmittelrückstände in dem Luftspalt, die über einen Waschprozess entfernt werden müssen, bevor der Luftspalt anschließend in einem Underfill-Prozess mit einem Isolationsmaterial vergossen wird. Eine vollständige Reinigung des Luftspalts ist dabei zwingend notwendig, damit der anschließende Verguss seine Funktion als Isolator zuverlässig erfüllen kann. Allerdings kann die Qualität der Reinigung und des anschließenden Vergusses nicht oder nur über eine zerstörende Prüfung inspiziert werden. Für einen optimalen und reproduzierbaren Underfill-Prozess ist ein sauberer Luftspalt mit definierter Spalthöhe entscheidend. Auch ist eine Mindestspalthöhe erforderlich.

Ein Problem bei der Anordnung von Prepackage-Modulen auf einer Trägerplatine ist eine mögliche Verkippung der Prepackage-Module an der Unterseite der Trägerplatine beim Lötprozess. Durch eine Verkippung ergeben sich mehrere Nachteile. So verschlechtert sich die thermische Anbindung des Prepackage-Moduls an einen Kühlkörper. Je größer die Verkippung ist, mit desto größerer Dicke ist ein thermisches Schnittstellenmaterial zwischen dem Prepackage-Modul und dem Kühlkörper einzusetzen, was die Kühlung wiederum negativ beeinflusst. Weiter erschwert ein in seiner Höhe variierender Luftspalt einen sauberen Waschprozess und Underfill-Prozess. Auch muss der Luftspalt zwischen dem Prepackage-Modul und der Trägerplatine ein eventuelles Verkippen des Prepackage-Moduls berücksichtigen, um in jedem Bereich die Mindestspalthöhe zu realisieren, so dass entsprechende Toleranzen vorzuhalten sind. Ein weiterer Nachteil liegt in einer potenziell reduzierten Lebensdauer der Lotverbindungen.

Der vorliegenden Erfindung liegt die Aufgabe zugrunde, ein elektrisches Modul und eine Leiterplattenanordnung bereitzustellen, die die Anordnung eines elektrischen Moduls an einer Leiterplatte mit einer möglichst geringen Verkippung des elektrischen Moduls ermöglichen.

Diese Aufgabe wird durch ein elektrisches Modul mit den Merkmalen des Anspruchs 1 und eine Leiterplattenanordnung mit den Merkmalen des Anspruchs 13 gelöst. Ausgestaltungen der Erfindung sind in den abhängigen Ansprüchen angegeben.

Danach betrachtet die Erfindung in einem ersten Erfindungsaspekt ein elektrisches Modul, das ein eingebettetes elektrisches Bauelement umfasst. Das elektrische Modul umfasst eine Oberseite und eine Unterseite, wobei die Oberseite vier rechteckig angeordnete Seitenkanten aufweist. Weiter umfasst das elektrische Modul mindestens drei an der Oberseite ausgebildete elektrische Lotpads, die einer elektrischen Kontaktierung des elektrischen Bauelements dienen und die dazu ausgebildet und vorgesehen sind, jeweils über eine Lotschicht mit einem zugeordneten elektrischen Lotpad einer Leiterplatte in Kontakt zu treten.

Es ist vorgesehen, dass die Lotpads des elektrischen Moduls in symmetrischer Anordnung auf der Oberseite des elektrischen Moduls angeordnet sind, wobei die Lotpads achsensymmetrisch an der Oberseite des elektrischen Moduls angeordnet sind und/oder sämtliche Lotpads sich entlang zweier gegenüberliegender Seitenkanten an der Oberseite des elektrischen Moduls erstrecken.

Die erfindungsgemäße Lösung beruht auf dem Gedanken, eine Verkippung des elektrischen Moduls an einer Leiterplatte durch das Design der Lotpads zu verhindern bzw. zu reduzieren. So ist eine achsensymmetrische oder auf zwei gegenüberliegende Seitenkanten beschränkte Anordnung der Lotpads vorgesehen, die bewirkt, dass das Lotmaterial, das beim Lötprozess eingesetzt wird, ebenfalls symmetrisch bezogen auf die Abmessungen des elektrischen Moduls zwischen dem elektrischen Modul und einer angrenzenden Leiterplatte ausgebildet ist. Hierdurch wird eine Verkippung des durch einen Lötprozess an der Unterseite einer Leiterplatte angeordneten elektrischen Moduls minimiert.

Ein weiterer, mit der erfindungsgemäßen Lösung verbundener Vorteil besteht darin, dass durch eine weitgehend konstante Spalthöhe des Spalts zwischen dem elektrischen Modul und der Leiterplatte auch ein sich an den Lötprozess anschließender Waschprozess und Underfill-Prozess optimiert werden können. Insbesondere ist ein gleichmäßiger Verguss zum Beispiel mit einem Underfill-Material zwischen dem elektrischen Modul und einer Leiterplatte möglich. Ebenso wird durch die reduzierte Verkippung des elektrische Moduls eine einfachere thermische Anbindung des elektrischen Moduls an einen Kühlkörper erreicht. Die vorliegende Erfindung stellt damit ein optimiertes Design des elektrischen Moduls für den Lötprozess, den Waschprozess und den Vergussprozess bereit.

Eine Ausgestaltung der Erfindung sieht vor, dass die Lotpads länglich ausgebildet und mindestens zwei der Lotpads parallel zueinander angeordnet sind. Die längliche und parallele Anordnung der Lotpads erlaubt es, dass Waschmittel während des Waschprozesses in einer Strömungsrichtung im Luftspalt zwischen dem elektrischen Modul und der Leiterplatte fließen kann. Durch die wesentlichen konstante Spalthöhe herrschen dabei zwischen den Lotpads im wesentlichen identische Strömungswiderstände vor. Der Einsatz verschiedener Strömungsrichtungen zur Reinigung des Spalts ist nicht erforderlich.

Eine weitere Ausgestaltung sieht vor, dass drei Lotpads derart achsensymmetrisch an der Oberseite des elektrischen Moduls angeordnet sind, dass ein Lotpad sich entlang einer Mittellinie (die eine Symmetrieachse der rechteckigen Oberseite darstellt) und die beiden anderen Lotpads sich entlang der der Mittellinie gegenüberliegenden Seitenkanten erstrecken. Hierdurch wird ein stabiler symmetrischer Aufbau bereitgestellt, der die Gefahr von Verkippungen minimiert.

Gemäß einer weiteren Ausgestaltung sind vier Lotpads derart achsensymmetrisch an der Oberseite des elektrischen Moduls angeordnet, dass zwei Lotpads sich benachbart zu einer Mittellinie und zwei Lotpads sich entlang der der Mittellinie gegenüberliegenden Seitenkanten erstrecken. Dabei werden beispielsweise die beiden mittleren, benachbart zu der Mittellinie angeordneten Lotpads mit dem gleichen Potential beaufschlagt, beispielsweise einem Source-Potential. Eine solche Ausgestaltung erlaubt es, vergrößerte Source- oder andere Kontakte bereitzustellen, ohne von einer symmetrischen Anordnung abzuweichen.

Eine weitere Ausgestaltung sieht vor, dass sämtliche Lotpads sich derart entlang zweier gegenüberliegender Seitenkanten erstrecken, dass jeweils die gleiche Anzahl an Lotpads sich an den gegenüberliegenden Seitenkanten erstreckt. Gemäß dieser Ausgestaltung eine vollständige Symmetrie der Lotpads im Hinblick auf ihre Anordnung an zwei gegenüberliegenden Seitenkanten vor. Da die Lotpads an gegenüberliegenden Seitenkanten maximal voneinander entfernt sind, wird die Gefahr einer Verkippung bei dieser Ausgestaltung in besonderer Weise minimiert.

Allgemein wird darauf hingewiesen, dass zu unterscheiden ist zwischen der Anzahl der Lotpads und der Anzahl der elektrischen Potentiale, mit denen die Lotpads beaufschlagt werden. In typischen Anwendungen sind drei elektrische Potentiale vorgesehen, mit denen das eingebettete Halbleiterbauelement beaufschlagt wird, beispielsweise ein Gate-Potential, ein Source-Potential und eine Drain-Potential. Die entsprechenden Potentiale werden über eine Leiterplatte bereitgestellt. Die Anzahl der Lotpads kann ebenfalls bei drei liegen, kann jedoch auch größer sein. In letzterem Fall werden mehrere Lotpads mit dem gleichen Potential beaufschlagt. Auf diese Weise bestehen zusätzliche Freiheiten, symmetrische Anordnungen der Lotpads zu realisieren.

Allgemein kann vorgesehen sein, dass sämtliche Lotpads die gleiche Fläche aufweisen. Dies bedeutet, dass auch das gleiche Lotpastenvolumen bei der Anordnung des elektrischen Moduls an einer Leiterplatte auf die Lotpads appliziert wird und dabei identische Lotschichthöhen realisiert werden, so dass die Gefahr von Verkippungen minimiert ist. Dabei kann vorgesehen sein, dass die Lotpaste an den einzelnen Lotpads zu gleichen oder ähnlichen Zeitpunkten verflüssigt wird. Eine Ausgestaltung sieht vor, dass die Lotpads auch alle die gleiche Breite aufweisen, so dass sie exakt formidentisch sind.

Gemäß einer weiteren Ausgestaltung ist vorgesehen, dass sämtliche Lotpads sich derart entlang zweier gegenüberliegender Seitenkanten erstrecken, dass einer der Lotpads an einer Seitenkante und die anderen Lotpads hintereinander entlang der gegenüberliegenden Seitenkante angeordnet sind. Um trotzdem eine symmetrische Verteilung der Lotpaste zu erreichen, kann in einem solchen Fall vorgesehen sein, dass die Summe der Flächen der Lotpads, die sich an der einen Seitenkante erstrecken, gleich der Fläche des Lotpads ist, das sich an der einen Seitenkante erstreckt. Dabei weisen die einzelnen Lotpads die identische Breite auf. Mit den Flächen sind auch die Volumina der Lotpasten bzw. Lotschichten identisch.

Bei einer solchen Ausgestaltung kann insbesondere vorgesehen sein, dass ein Drain-Kontakt durch das Lotpad an der einen Seitenkante und ein Source-Kontakt sowie ein Gate-Kontakt durch Lotpads an der anderen Seitenkante bereitgestellt werden, so dass der Drain-Kontakt und der Source-Kontakt räumlich gegenüber angeordnet sind. Gleichzeitig sind der Source-Kontakt und der Gate-Kontakt zueinander auf einer Linie ausgerichtet.

Eine weitere Ausgestaltung sieht vor, dass die Flächen der drei Lotpads derart in einem Verhältnis zueinanderstehen, dass eines der Lotpads (beispielsweise der Gate-Kontakt) eine geringste Fläche hat und die beiden anderen Lotpads jeweils ein Vielfaches dieser geringsten Fläche besitzen (wobei der Source-Kontakt beispielsweise ein zweifaches der geringsten Fläche besitzt und der Drain-Kontakt ein dreifaches der geringsten Fläche besitzt).

Allgemein wird darauf hingewiesen, dass das Merkmal, dass ein Lotpad sich entlang einer Seitenkante erstreckt, nicht notwendigerweise bedeutet, dass das Lotpad sich exakt bis zu der Seitenkante erstreckt. Vielmehr kann ebenso vorgesehen sein, dass zwischen der Seitenkante und dem Lotpad ein geringfügiger, konstanter Abstand besteht. Das jeweilige Lotpad ist jedoch näher an der Seitenkante als an der Mittellinie angeordnet.

Weitere Ausgestaltungen des elektrischen Moduls sehen vor, dass sich ausgehend von den Lotpads Durchkontaktierungen in das Innere des elektrischen Moduls erstrecken, die sich zu einer inneren Metallisierungsschicht des elektrischen Moduls oder zu Kontakten an der Oberseite des elektrischen Bauelements erstrecken. Die Position der Kontakte an der Oberseite des elektrischen Bauelements bestimmt dabei auch die grundlegende Position der zugeordneten Lotpads, da innerhalb des elektrischen Moduls keine Umverdrahtung erfolgt.

Wie bereits erwähnt, kann vorgesehen sein, dass die mindestens drei Lotpads des elektrischen Moduls mit einem Drain-Potential, einem Source-Potential und einem Gate-Potential beaufschlagt sind. Dabei kann weiter vorgesehen sein, dass das sich entlang der einen Seitenkante erstreckende Lotpad mit einem Source-Potential beaufschlagt ist und dass das sich entlang der anderen Seitenkante erstreckende Lotpad mit einem Drain-Potential beaufschlagt ist. Wie noch erläutert wird, erlaubt eine solche Spannungsbeaufschlagung der Lotpads, zwei benachbarte elektrische Module, die Bestandteile von zwei Schaltern sind, in einer Halbbrückenschaltung in einfacher Weise zu verschalten. Für eine solche Spannungsbeaufschlagung ist es erforderlich, das eingebettete elektrische Bauelement im Modul so auszurichten, dass seine für einen Source-Anschluss und einen Drain-Anschluss vorgesehenen Oberflächenkontakte entsprechend positioniert sind.

Das elektrische Modul ist beispielsweise derart ausgebildet, dass es aufweist:
- einen keramischen Schaltungsträger, der eine isolierende Keramikschicht und eine auf der Oberseite der Keramikschicht angeordnete erste Metallisierungsschicht aufweist, wobei das elektrische Bauelement auf der Oberseite der ersten Metallisierungsschicht angeordnet und elektrisch mit dieser verbunden ist,
- wobei die elektrischen Kontakte des Moduls eine erste Durchkontaktierung umfassen, die sich von einem der Lotpads an der Oberseite bis zu der ersten Metallisierungsschicht erstreckt, sowie zweite und dritte Durchkontaktierungen umfassen, die sich von anderen der Lotpads an der Oberseite zu entsprechenden Kontakten an der Oberseite des elektrischen Bauelements erstrecken.

Bei dem in das elektrische Modul integrierten elektrischen Bauelement kann es sich um ein Halbleiterbauelement, insbesondere einen Leistungshalbleiter wie z.B. einen Leistungs-MOSFET oder ein IGBT-Bauelement handeln. Es handelt sich beispielsweise um einen Leistungshalbleiter eines Wechselrichters oder allgemein eines Stromrichters, der für den Betrieb eines Elektromotors vorgesehen ist.

In einem weiteren Erfindungsaspekt betrifft die vorliegende Erfindung eine Leiterplattenanordnung, die eine Leiterplatte und mindestens ein elektrisches Modul gemäß Anspruch 1 aufweist. Dabei sind an der Unterseite der Leiterplatte elektrische Lotpads ausgebildet, die den elektrischen Lotpads an der Oberseite des elektrischen Moduls zugeordnet sind, wobei die jeweiligen Lotpads über eine Lotschicht elektrisch verbunden sind. Ein Spalt zwischen der Oberseite des elektrischen Moduls und der Unterseite der Leiterplatte ist durch ein Vergussmaterial verschlossen.

Es wird darauf hingewiesen, dass im Sinne der vorliegenden Erfindung stets diejenige Seite der Leiterplatte, an der das elektrische Modul angeordnet ist, als Unterseite der Leiterplatte bezeichnet wird, unabhängig von der tatsächlichen räumlichen Ausrichtung der Leiterplatte und des Moduls.

Eine Ausgestaltung der Leiterplattenanordnung sieht vor, dass
- die elektrischen Module jeweils mindestens drei Lotpads aufweisen, wobei sich an zwei gegenüberliegenden Seitenkanten jeweils mindestens ein Lotpad erstreckt, und
- die elektrischen Module in zwei Reihen an der Leiterplatte angeordnet und dabei jeweils zwei benachbarte elektrische Module der beiden Reihen derart ausgerichtet sind, dass die mit Lotpads versehenen Seitenkanten miteinander fluchten und sich dabei senkrecht zur Längsrichtung der jeweiligen Reihe erstrecken,
- so dass ein Waschmittelstrom durch jeweils zwei benachbarte elektrischer Module der beiden Reihen in einem Zwischenstadium der Herstellung der Leiterplattenanordnung realisierbar ist, wobei der Waschmittelstrom sich jeweils zwischen der Leiterplatte und der Oberseite des elektrischen Moduls und dabei zwischen den an den gegenüberliegenden Seitenkanten ausgebildeten Lotpads erstrecken kann. Dabei sind die elektrischen Bauelemente, die in das elektrische Modul eingebettet sind, derart auszurichten, dass die Lotpads entsprechend orientiert sind.

Diese Erfindungsvariante erlaubt es, aufwändige Waschprozesse nach dem Lötprozess zu vermeiden und gleichzeitig eine zuverlässige Reinigung des Luftspalts zwischen dem elektrischen Modul und der Leiterplatte sicherzustellen. Dabei ergibt sich eine Strömungsrichtung für das Waschmittel zwischen gegenüberliegenden Seitenkanten und den dort angeordneten Lotpads des jeweiligen Moduls, wobei das Waschmittel jeweils zwei benachbarte Module während des Waschprozesses durchströmt. Da von den in zwei Reihen angeordneten elektrischen Modulen jeweils nur zwei der elektrischen Module (je ein Modul von jeder Reihe) von einem Waschmittelstrom durchströmt werden, ergibt sich eine relativ kurze Strecke für den Waschmittelstrom und damit eine effektive Reinigung durch das Waschmittel im Vergleich zu einer dazu alternativen Ausgestaltung, bei der sämtliche elektrischen Module einer Reihe durch einen Waschmittelstrom gereinigt und durchspült werden. So sind im letzteren Fall deutlich längere Wege zur Durchspülung aller benachbarter elektrischer Module erforderlich. Ein weiterer, mit dieser Ausgestaltung verbundener Vorteil besteht darin, dass die Anordnung der Lotpads bei den benachbart angeordneten elektrischen Modulen zu parallelen Kontaktflächenbereichen führt. Dies verhindert Abschattungseffekte und damit "blinde" Stellen, an die das Waschmittel nicht gelangen kann.

Es wird darauf hingewiesen, dass die erläuterten Waschprozesse zwar zu einem Zeitpunkt stattfinden, zu dem die Leiterplattenanordnung noch nicht fertig hergestellt ist, nämlich nach dem Lötprozess und vor dem Underfill-Prozess. Gleichwohl handelt es sich hierbei um ein Merkmal der fertig hergestellten Leiterplattenanordnung, der allein durch die Position der Lotpads auf der Oberseite des elektrischen Moduls definiert ist, in welcher Weise der Waschprozess erfolgen kann.

Eine Ausgestaltung sieht vor, dass die elektrischen Module jeweils drei Lotpads aufweisen, die sich entlang einer Mittellinie und zweier Seitenkanten erstrecken, wobei jeweils zwei benachbarte elektrische Module der beiden Reihen derart ausgerichtet sind, dass auch die beiden sich entlang der Mittellinie erstreckenden Lotpads miteinander fluchten. Damit entstehen über die Lotpads und das auf diese applizierte Lotmaterial zwei parallele Strömungen für ein Waschmittel zwischen der Oberseite des elektrischen Moduls und der Unterseite der Leiterplatte.

Eine weitere Ausgestaltung sieht vor, dass
- die mindestens drei Lotpads jedes elektrischen Moduls mit einem Source-Potential, einem Drain-Potential und einem Gate-Potential beaufschlagt sind, und
- zwei benachbarte elektrische Module einer Reihe jeweils derart ausgerichtet sind, dass ein an einer Seitenkante angeordnetes Lotpad des einen elektrischen Moduls, das mit einem Source-Potential beaufschlagt ist, nicht an ein Lotpad an der benachbarten Seitenkante des benachbarten elektrischen Moduls, das mit einem Drain-Potential beaufschlagt ist, angrenzt.

Um dies zu erreichen, kann vorgesehen sein, dass für zwei benachbarte elektrische Module einer Reihe jeweils gilt, dass das eine elektrische Modul relativ zu dem anderen elektrischen Modul um 180° gedreht angeordnet ist. Entsprechend sind auch die jeweiligen elektrischen Bauelemente, die in das elektrische Modul eingebettet sind, um 180° zueinander zu drehen.

Diese Ausgestaltung der Erfindung beruht auf der Erkenntnis, dass für die elektrische Trennung zwischen dem Drain-Anschluss und dem Source-Anschluss eines elektrischen Moduls eines logischen Schalters die größten Luft- und Kriechstrecken erforderlich sind.

Durch die genannte Ausrichtung von Drain-Anschluss und Source-Anschluss am elektrischen Modul wird in natürlicher Weise ein großer Abstand zwischen diesen Anschlüssen hergestellt, da bei dieser Anordnung an den einander angrenzenden Seitenkanten zweier benachbarter elektrischer Module jeweils zwei Drain-Anschlüsse oder zwei Source-Anschlüsse aneinander angrenzen. Damit werden keine zusätzlichen Abstände aus der Isolationskoordination benötigt.

Eine weitere Ausgestaltung der Erfindung sieht vor, dass die mindestens drei Lotpads des jeweiligen elektrischen Moduls mit einem Source-Potential, einem Source-Potential und einem Gate-Potential beaufschlagt sind, wobei das sich entlang der einen Seitenkante erstreckende Lotpad mit einem Drain-Potential beaufschlagt ist und dass sich entlang der anderen Seitenkante erstreckende Lotpad mit einem Source-Potential beaufschlagt ist. Dabei ist weiter vorgesehen, dass die elektrischen Module in zwei Reihen an der Leiterplatte angeordnet und dabei jeweils zwei benachbarte elektrische Module der beiden Reihen derart ausgerichtet sind, dass ein an einer Seitenkante angeordnetes Lotpad des einen elektrischen Moduls, das mit einem Drain-Potential beaufschlagt ist, an ein Lotpad an der benachbarten Seitenkante des benachbarten elektrischen Moduls angrenzt, das mit einem Source-Potential beaufschlagt ist. Dabei sind die elektrischen Bauelemente, die in das jeweilige elektrische Modul eingebettet sind, derart auszurichten, dass die Lotpads entsprechend orientiert sind.

Diese Ausgestaltung erlaubt es, zwei elektrische Module ohne eine aufwändige Umverdrahtung in der Leiterplatte insbesondere zur Realisierung einer Halbbrückenschaltung miteinander zu verbinden. Dabei können ein Drain-Kontakt und ein Source-Kontakt zweier benachbarter elektrischer Module auf das gleiche Potential gelegt werden, ohne dass in der Leiterplatte eine Umverschaltung erfolgen muss.

Die genannten Reihen von elektrischen Modulen bilden in Ausgestaltungen der Erfindung jeweils einen logischen Schalter. Dabei kann vorgesehen sein, dass die Schalter über eine entsprechende Verdrahtung in der Leiterplatte zu einer Halbbrückenschaltung zusammengeschaltet sind, in der der Drain-Kontakt des einen Schalters und der Source-Kontakt des anderen Schalters auf demselben Potential liegen.

Die Erfindung wird nachfolgend unter Bezugnahme auf die Figuren der Zeichnung anhand mehrerer Ausführungsbeispiele näher erläutert. Es zeigen:
- Figur 1: eine Draufsicht auf die Oberseite eines Ausführungsbeispiels eines elektrischen Moduls, wobei die Oberseite des elektrischen Moduls drei symmetrisch angeordnete Lotpads aufweist;
- Figur 2: das elektrische Modul der Figur 1, wobei auf die Lotpads jeweils eine Lotschicht appliziert ist;
- Figur 3: das elektrische Modul der Figur 1, wobei schematisch Strömungspfade eines Waschmittels dargestellt sind, das bei einem Waschprozess zwischen der Oberseite des Moduls und einer angrenzenden Leiterplatte strömt;
- Figur 4: eine Draufsicht auf die Oberseite eines weiteren Ausführungsbeispiels eines elektrischen Moduls, wobei die Oberseite des elektrischen Moduls vier symmetrisch angeordnete Lotpads aufweist;
- Figur 5: eine Draufsicht auf die Oberseite eines weiteren Ausführungsbeispiels eines elektrischen Moduls, wobei die Oberseite des elektrischen Moduls an einer Seitenkante ein Lotpad und an der gegenüberliegenden Seitenkante zwei Lotpads aufweist;
- Figur 6: eine Draufsicht auf die Oberseite eines weiteren Ausführungsbeispiels eines elektrischen Moduls, wobei die Oberseite des elektrischen Moduls an einer Seitenkante drei Lotpads und an der gegenüberliegenden Seitenkante drei weitere Lotpads aufweist;
- Figur 7: in einer Ansicht von oben eine Anordnung von elektrischen Modulen gemäß der Figur 5, wobei die elektrischen Module in zwei parallelen Reihen angeordnet sind, die zwei elektrische Schalter bilden;
- Figur 8: eine Darstellung von zwei in einer Reihe nebeneinander angeordneten elektrischen Modulen der Figur 7, wobei die Lotpads der elektrischen Module derart mit einer Gate-Spannung, einer Source-Schaltung und einer Drain-Schaltung beaufschlagt sind, dass die mit einer Source-Spannung beaufschlagten Lotpads an benachbarten Seitenkanten der beiden Module ausgebildet sind;
- Figur 9: in einer Ansicht von oben eine Anordnung von elektrischen Modulen gemäß der Figur 1, wobei die elektrischen Module in zwei parallelen Reihen angeordnet sind, die zwei elektrische Schalter bilden;
- Figur 10: eine Darstellung von zwei in einer Reihe nebeneinander angeordneten elektrischen Modulen der Figur 9, wobei die Lotpads der elektrischen Module derart mit einer Gate-Spannung, einer Source-Schaltung und einer Drain-Schaltung beaufschlagt sind, dass die mit einer Source-Spannung beaufschlagten Lotpads an benachbarten Seitenkanten der beiden Module ausgebildet sind;
- Figur 11: in einer Ansicht von oben eine weitere Anordnung von elektrischen Modulen gemäß der Figur 1, wobei die elektrischen Module in zwei parallelen Reihen angeordnet sind, die zwei elektrische Schalter bilden, und wobei die elektrischen Module im Vergleich zu der Anordnung der Figur 9 um 90° gedreht sind, so dass die Lotpads eines Moduls der einer Reihe jeweils parallel zur den Lotpads des benachbarten Moduls der anderen Reihe verlaufen, und wobei sich ein Drain-Anschluss und ein Gate-Anschluss an den einander zugewandten Seitenkanten der benachbarten Module gegenüber liegen;
- Figur 12: schematisch einen Schnitt durch zwei benachbarte Module der beiden Reihen der Figur 11 unter schematischer Darstellung einer in der Leiterplatte erforderlichen Umverschaltung;
- Figur 13: zwei elektrische Module entsprechend der Figur 11, die in zwei parallelen Reihen angeordnet sind, wobei sich die Spannungsbeaufschlagung der Lotpads gegenüber der Figur 11 dahingehend geändert hat, dass sich ein Drain-Anschluss und ein Source-Anschluss an den einander zugewandten Seitenkanten der Module gegenüber liegen;
- Figur 14: schematisch einen Schnitt die beiden benachbarten Module der Figur 13 unter Darstellung einer unmittelbaren Verbindung zwischen dem Drain-Anschluss des einen Moduls und dem Source-Anschluss des anderen Moduls über die Leiterplatte;
- Figur 15: eine Draufsicht auf die Oberseite eines weiteren Beispiels eines elektrischen Moduls, das an seiner Oberseite drei Lotpads ausbildet, wobei zwei der Lotpads an gegenüberliegenden Seitenkanten und ein drittes Lotpad großflächig mittig auf der Oberseite angeordnet ist, und wobei eines der an der Seitenkante angeordneten Lotpads und das mittige dritte Lotpad die Abmessungen eines eingebetteten elektrischen Bauelements des elektrischen Moduls teilweise abdecken;
- Figur 16: ein elektrisches Modul entsprechend der Figur 15, wobei das eine Lotpad und das mittige Lotpad durch eine vergrößerte Fläche die Abmessungen des eingebetteten elektrischen Bauelements zu mehr 90 % abdecken;
- Figur 17: ein elektrisches Modul entsprechend der Figur 15, wobei das mittige Lotpad durch eine weiter vergrößerte Fläche die Abmessungen des eingebetteten elektrischen Bauelements an mindestens einer Seitenkante überdeckt und dabei über den Rand des elektrischen Bauteils übersteht;
- Figur 18: ein elektrisches Modul gemäß der Figur 15 und ein elektrisches Modul der Figur 17 in Draufsicht und in schematischer Schnittansicht im Vergleich; und
- Figur 19: beispielhaft den Aufbau einer Leiterplattenanordnung mit einer Leiterplatte und einem elektrischen Modul.

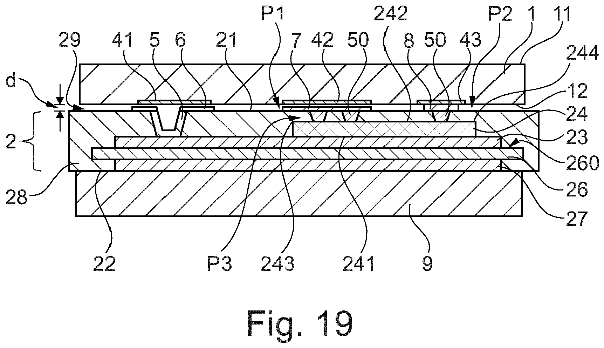

Zum besseren Verständnis der vorliegenden Erfindung wird zunächst anhand der Figur 19 beispielhaft der Aufbau einer Leiterplattenanordnung beschrieben.

Die Figur 19 zeigt eine Leiterplattenanordnung, die eine Leiterplatte 1 und ein elektrisches Modul 2 umfasst. Die Leiterplatte 1 umfasst eine Oberseite 11 und eine Unterseite 12. An der Unterseite 12 sind eine Mehrzahl von Lotpads 41, 42, 43 zur Kontaktierung des elektrischen Moduls 2 vorgesehen.

Das elektrische Modul 2 weist eine Oberseite 21 und eine Unterseite 22 auf. Es umfasst einen keramischen Schaltungsträger 260, ein elektrisches Bauelement 24 und elektrische Kontakte 6, 7, 8, die auf der Oberseite 21 des Moduls 2 angeordnet sind. Der keramischen Schaltungsträger 260 umfasst eine isolierende Keramikschicht 26, eine auf der Oberseite der Keramikschicht 26 angeordnete Metallisierungsschicht 23 und eine auf der Unterseite der Keramikschicht 26 angeordnete weitere Metallisierungsschicht 27. Die Keramikschicht 26 besteht beispielsweise aus Aluminiumnitrid (AIN) oder Siliziumnitrid (Si₃N₄). Die Metallisierungsschichten 23, 27 bestehen beispielsweise aus Kupfer, Aluminium, Silber oder Wolfram.

Auf der Metallisierungsschicht 23 ist über eine Lotschicht (nicht gesondert dargestellt) das elektrisches Bauelement 24 angeordnet. Das Bauelement 24 weist dabei eine Unterseite 241, mit der es auf der Metallisierungsschicht 23 angeordnet ist, und eine Oberseite 242 auf. Es besitzt dabei eine Dicke, die sich aus dem Abstand zwischen der Oberseite 242 und der Unterseite 241 ergibt. Die Oberseite 242 und die Unterseite 241 können metallisiert, zum Beispiel verkupfert sein. Bei dem elektrischen Bauelement 24 handelt es sich beispielsweise um einen Leistungshalbleiter, der als Chip ausgebildet ist.

Der keramischen Schaltungsträger 260 und das elektrische Bauelement 24 sind in einem Substrat 28 angeordnet, das die Außenmaße des elektrischen Moduls 2 definiert. Bei dem Substrat 28 handelt es sich in einer Ausführungsvariante um eine Vergussmasse, in die der keramischen Schaltungsträger 260 und das elektrische Bauelement 24 eingebettet sind. Alternativ handelt es sich bei dem Substrat 28 um eine Leiterplatte, für welchen Fall der keramischen Schaltungsträger 260 und das elektrische Bauelement 24 in einem Leiterplattenembeddingprozess in eine Leiterplatte eingebettet worden sind.

Das elektrische Bauelement 24 ist als eingebettetes Bauelement ausgebildet, d. h. seine Oberseite 242 ist von der Oberseite 21 des elektrischen Moduls beabstandet.

Das Substrat 28 umfasst eine Oberseite, die auch die Oberseite 21 des Moduls 2 bildet. Die Unterseite des Substrat 28 verläuft bündig mit der unteren Metallisierungsschicht 27, die die Unterseite 22 des Moduls 2 bildet. Der keramische Schaltungsträger 260 ist mit der unteren Metallisierungsschicht 27 direkt oder über eine nicht dargestellte Wärmeleitmatte mit einem Kühlkörper 9 verbindbar. Über den Kühlkörper 9 wird Verlustwärme des elektrischen Bauelements 24 abgeführt.

Die elektrische Kontakte 6, 7, 8 an der Oberseite 21 des Moduls werden durch Lotpads bereitgestellt, die auch als Lötkontakte bezeichnet werden. Die Lotpads 6, 7, 8 sind über Lotverbindungen (nicht dargestellt) mit den Lotpads 41, 42, 43 der Leiterplatte 1 elektrisch verbunden. Dabei werden über das Lotpad 6 beispielsweise ein Drain-Anschluss und über die Lotpads 7, 8 ein Source-Anschluss und ein Gate-Anschluss des elektrischen Bauelements 24 bereitgestellt.

Es liegt prinzipbedingt ein Spalt 29 zwischen der Oberseite 21 des Moduls 2 und der Unterseite 12 der Leiterplatte 1 vor. Dabei bestimmt die Lotschichtdicke die Höhe d des Spalts 29. Der Spalt 29 bildet nach dem Lötprozess, bei dem das Modul 2 mit der Leiterplatte 1 verlötet wird, einen Luftspalt. In einem sich an den Lötprozess einschließenden Waschprozess wird der Luftspalt mittels eines Waschmittels von Flussmittelrückständen gereinigt. Anschließend erfolgt in einem Underfill-Prozess eine Befüllung des Spaltes 29 mit einem isolierende Vergussmaterial. Der Spalt 29 sollte eine möglichst konstante Höhe d aufweisen, damit diese Prozesse effektiv durchgeführt werden können.

Von dem Lotpad 6 gehen Durchkontaktierungen 5 aus, die sich zu der oberen Metallisierungsschicht 23 des keramischen Schaltungsträgers 260 erstrecken. Weiter gehen von den Lotpads 7, 23 Durchkontaktierungen 50 aus, die sich zu der Oberseite 242 des elektrischen Bauelements 24 erstrecken. Als Durchkontaktierung bzw. Via wird dabei eine innen metallisierte Bohrung bezeichnet. Dabei kann jeweils eine größere Anzahl von Durchkontaktierungen 5, 50 vorgesehen sein, die hintereinander angeordnet und in der Schnittdarstellung der Figur 19 daher nicht erkennbar sind.

Das Modul 2 ist insgesamt quaderförmig ausgebildet, so dass die Oberseite rechteckig ist und vier Seitenkanten aufweist, von denen jeweils zwei einander parallel gegenüber liegen.

Im Folgenden wird die Anordnung der Lotpads 6-8 auf dem elektrischen Modul 2 betrachtet, die in der Figur 19 nur schematisch dargestellt ist.

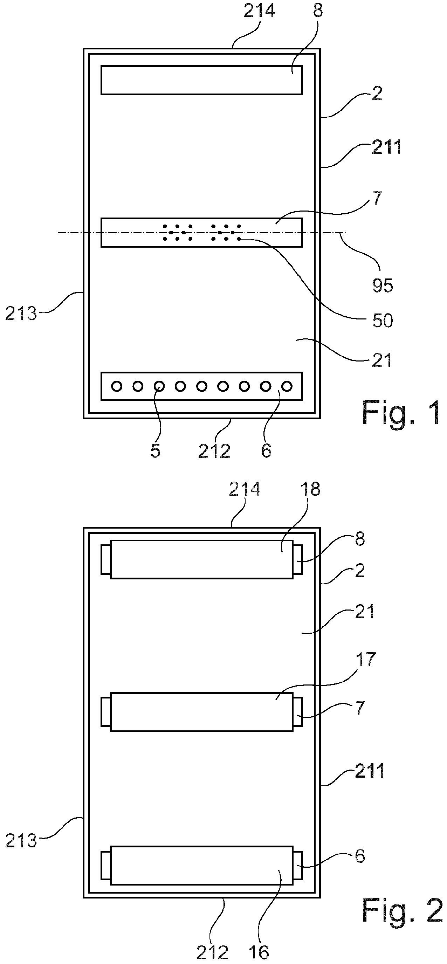

Die Figur 1 zeigt eine Draufsicht auf die Oberseite 21 eines elektrischen Moduls 2, das ein eingebettetes elektrisches Bauelement aufweist (entsprechend z.B. dem elektrischen Bauelement 24 der Figur 19). Das elektrische Modul 2 ist quaderförmig ausgebildet, so dass die Oberseite 21 vier Seitenkanten 211-214 aufweist, von denen jeweils zwei parallel zueinander angeordnet sind. Die Oberseite 21 weist naturgemäß zwei Mittellinien bzw. Symmetrieachsen auf, wobei einer der Mittellinien 95 dargestellt ist.

Auf der Oberseite 2 sind achsensymmetrisch drei Lotpads 6, 7, 8 angeordnet. Dabei befindet sich das eine Lotpad 7 auf der Mittellinie 95 und sind die beiden anderen Lotpads 6, 8 jeweils angrenzend an eine der Seitenkanten 212, 214 angeordnet, so dass insgesamt eine Achsensymmetrie der Anordnung der Lotpads gegeben ist. Die einzelnen Lotpads 6, 7, 8 weisen die gleiche Länge und die gleiche Breite und somit auch die gleiche Fläche auf. Sie sind länglich ausgebildet und verlaufen im Wesentlichen über die gesamte Breite des jeweiligen Lotpads, wobei dies nicht notwendigerweise der Fall ist. Die Lotpads 6, 8 können exakt an der Seitenkante 212, 214 oder, wie in der Figur 1 dargestellt, mit einem gewissen Abstand zu jeweiligen Seitenkante 212, 214 verlaufen. Auch verlaufen die Lotpads 6, 7, 8 parallel zueinander.

In der Figur 1 ist ebenfalls zu erkennen, dass sich von den Lotpads Durchkontaktierungen in das Innere des Moduls erstrecken. So sind schematisch dem Lotpad 6 zugeordnete Durchkontaktierungen 5 und dem Lotpad 7 zugeordnete Durchkontaktierungen 50 dargestellt, die entsprechend den Durchkontaktierungen 5, 50 der Figur 19 der Kontaktierung des eingebetteten elektrischen Bauelements dienen.

Es wird darauf hingewiesen, dass die Lotpads 6, 7, 8 nicht notwendigerweise von vornherein die dargestellte Anordnung und Form aufweisen müssen. Beispielsweise kann vorgesehen sein, dass die Lotpads mit größerer Fläche auf der Oberseite 21 des elektrischen Moduls 2 ausgebildet worden sind, für welchen Fall durch anschließendes Aufbringen einer Lötstopppaste auf die Lotpads dann die gewünschte und dargestellte Form hergestellt wird. Alternativ werden die Lotpads 6, 7, 8 von vornherein in der dargestellten Form auf der Oberseite 21 des elektrischen Moduls 2 ausgebildet. Dies gilt in entsprechender Weise auch für die Figuren 2 bis 14.

Die Figur 2 zeigt das elektrische Modul der Figur 1 unter zusätzlicher Darstellung von Lotschichten 16, 17, 18, die auf den jeweiligen Lotpads 6, 7, 8 angeordnet sind. Über die Lotschichten 16, 16, 18 ist das elektrische Modul 2 elektrisch mit einer Leiterplatte entsprechend der Leiterplatte 1 der Figur 19 verbunden. Da die Lotpads 6, 7, 8 jeweils die gleiche Fläche aufweisen, können Sie mit dem gleichen Lotpastenvolumen versehen werden, so dass auch die Lotschichten 16, 17, 18 exakt das gleiche Volumen aufweisen und damit die gleiche Höhe besitzen, so dass das elektrische Modul 2 verkippungsarm an einer Leiterplatte angeordnet werden kann. Dabei kann zusätzlich vorgesehen sein, dass die jeweilige Lotpaste zu gleichen oder ähnlichen Zeitpunkten im Lötprozess verflüssigt wird, was eine mögliche Verkippung des elektrischen Moduls 2 weiter reduziert.

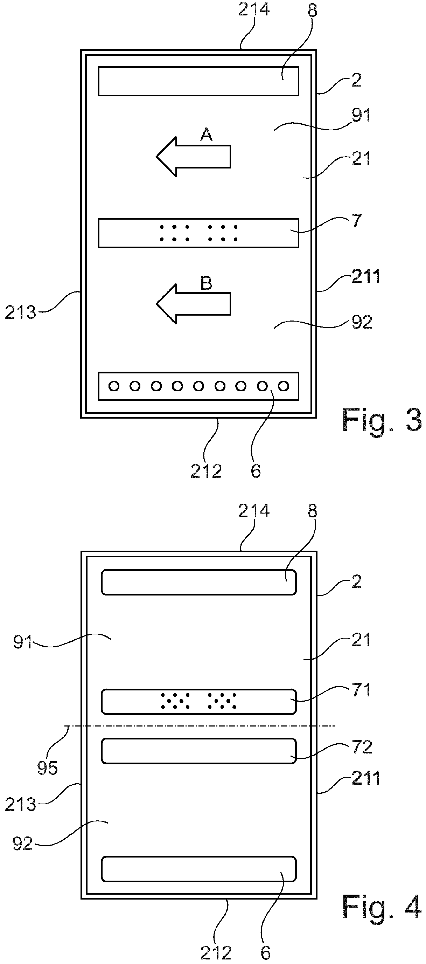

Die Figur 3 verdeutlicht, dass die Konfiguration der Lotpads 6, 7, 8 entsprechend der Figur 1 zwei Strömungskanäle 91, 92 bereitstellt, die sich zwischen dem jeweiligen randseitigen Lotpad 6, 8 und dem mittigen Lotpad 7 ausbilden. In den Strömungskanälen 91, 92 kann mit einer Strömungsrichtung A, B ein Waschmittel strömen, dass, wie in Bezug auf die Figuren 19 erläutert, einer Reinigung eines Luftspalts dient, der nach dem Lötprozess zur Verbindung des elektrischen Moduls 2 mit einer Leiterplatte zwischen diesen existiert und mit Flussmittelrückständen vom Lötprozess verunreinigt ist. In den beiden Strömungskanälen 91, 92 liegen dabei aufgrund der achsensymmetrischen Anordnung der Lotpads identische Strömungswiderstände vor, d. h. der zu reinigende Luftspalt wird in zwei identische Kammern aufgeteilt. Dabei braucht nur eine Strömungsrichtung A, B für ein Waschmittel bereitgestellt werden. Die Lotpads 6, 7, 8 sind somit für den Waschprozess optimiert ausgerichtet. Dies gilt auch für einen sich an den Waschprozess anschließenden Vergussprozess.

Die Lotpads 6, 7, 8 der Figuren 1-3 sind beispielsweise mit einem Drain-Potential, einem Source-Potential und einem Gate-Potential beaufschlagt, wobei es sich bei dem eingebetteten elektrischen Bauelement des elektrischen Moduls beispielsweise um einen Leistungshalbleiter handelt. Die mit einer entsprechenden Spannung beaufschlagten Lotpads 6, 7, 8 werden nachfolgend auch als Drain-Anschluss, Source-Anschluss und Gate-Anschluss bzw. Source-Kontakt, Drain-Kontakt und Gate-Kontakt bezeichnet. Bezeichnet. Wie noch erläutert wird, kann dabei vorgesehen sein, dass ein bestimmtes Potential an mehrere Lotpads angelegt wird.

Die Figur 4 zeigt ein Ausführungsbeispiel, bei dem eine achsensymmetrische Anordnung von Lotpads an der Oberseite 21 eines elektrischen Moduls 2 dadurch realisiert ist, dass zwei Lotpads 71, 72 benachbart zur Mittellinie 95 verlaufen und zwei weitere Lotpads 6, 8 sich entlang der der Mittellinie 95 gegenüberliegenden Seitenkanten 212, 214 erstrecken. Dabei ist beispielsweise vorgesehen, dass das Lotpad 6 einen Drain-Kontakt bildet, die Lotpads 71, 72 Source-Kontakte bilden und das Lotpad 8 einen Gate-Kontakt bildet. Auch bei einer solchen Ausgestaltung werden zwei im wesentlichen identische Strömungskanäle 91, 92 für ein Waschmittel bereitgestellt.

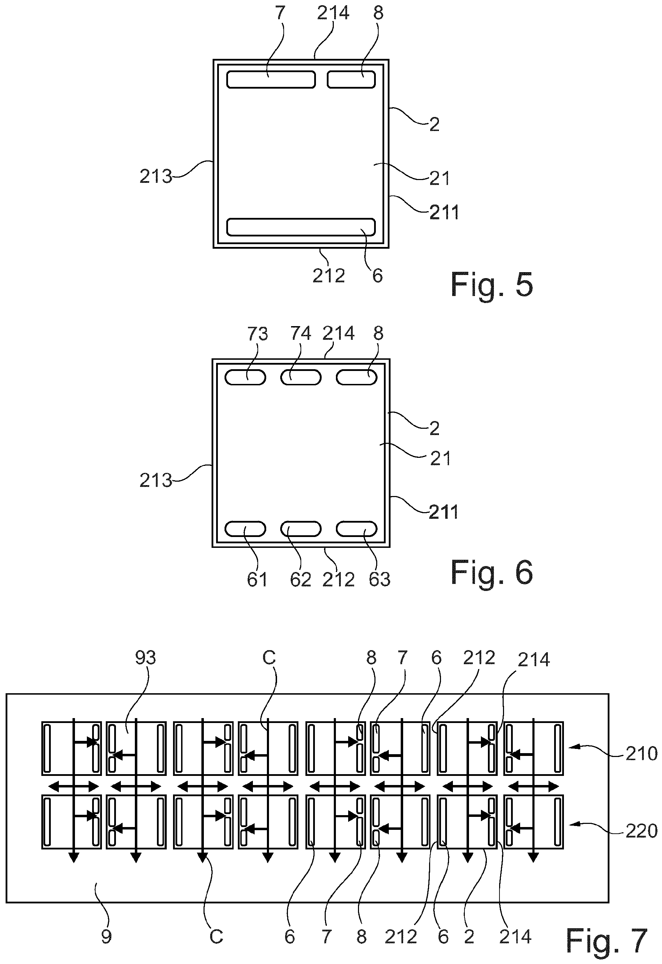

Die Figur 5 zeigt ein weiteres Ausführungsbeispiel einer symmetrischen Anordnung von Lotpads auf der Oberseite eines elektrischen Moduls. So sind bei der Ausgestaltung der Figur 5 insgesamt drei Lotpads 6, 7, 8 vorgesehen, wobei das eine Lotpad 6 sich entlang der einen Seitenkante 212 und die beiden anderen Lotpads 7, 8 sich entlang der gegenüberliegenden Seitenkante 214 erstrecken. Dabei sind die beiden anderen Lotpads 7, 8 hintereinander entlang der Seitenkante 214 angeordnet. Es ist vorgesehen, dass die Summe der Flächen der beiden Lotpads 7, 8 gleich der Fläche des Lotpads 6 ist. Hierdurch wird eine gleiche Verteilung der Lotpaste an den beiden Seitenkanten 212, 214 sichergestellt.

Die einzelnen Lotpads 6, 7, 8 weisen die gleiche Breite auf. Die Flächen der drei Lotpads 6, 7, 8 stehen derart in einem Verhältnis zueinanderstehen, dass das Lotpad 7 die doppelte und das Lotpad 6 die dreifache Fläche des Lotpads 8 aufweist. Die Lotpads 6 und 7 weisen also jeweils ein Vielfaches der Fläche des Lotpads 8 auf.

Auch bei dem Ausführungsbeispiel der Figur 5 ist vorgesehen, dass das Lotpad 6 einen Drain-Kontakt bildet, das Lotpad 7 einen Source-Kontakt bildet und das Lotpad 8 einen Gate-Kontakt bildet. Dementsprechend sind der Source-Kontakt und der Drain-Kontakt räumlich gegenüberliegend angeordnet.

Die Figur 6 zeigt ein weiteres Ausführungsbeispiel, das vom grundsätzlichen Aufbau dem Ausführungsbeispiel der Figur 5 entspricht, wobei jedoch der Gate-Kontakt in drei Lotpads 61, 62, 63 und der Source-Kontakt in zwei Lotpads 73, 74 segmentiert wurde. Hierdurch liegt eine vollständige Symmetrie in Bezug auf die Mittelachse und eine symmetrische Verteilung der Lotpads und zugehörigen Lotschichten auf zwei Seitenkanten 212, 214 vor.

Die Figur 7 zeigt eine Mehrzahl von elektrischen Modulen 2, die entsprechend der Figur 5 ausgebildet sind. Die elektrischen Module 2 sind in zwei parallelen Reihen 210, 220 angeordnet. Jede Reihe 210, 220 von Modulen 2 bildet dabei einen logischen Schalter, beispielsweise einen logischen Schalter in einem Wechselrichter oder Umrichter. In der dargestellten Ansicht von oben ist ein Kühlkörper 9 zu erkennen, auf dem die elektrischen Module entsprechend der Figur 19 angeordnet sind. Auf der Oberseite der elektrischen Module ist entsprechend der Figur 19 eine Leiterplatte angeordnet, die jedoch in der Figur 7 nicht dargestellt ist.

Die elektrischen Module 2 sind derart ausgerichtet, die Lotpads eines elektrischen Moduls 2 der einen Reihe 210 mit den Lotpads des benachbarten elektrischen Moduls 2 der anderen Reihe 220 fluchten und sich dabei senkrecht zur Längsrichtung der jeweiligen Reihe 210, 220 erstrecken. So fluchten die Seitenkanten 214, die die Lotpads 7, 8 der Figur 5 ausbilden. Weiter fluchten die Seitenkanten 212, die die Lotpads 6 der Figur 5 ausbilden. Durch diese Anordnung ergeben sich Strömungskanäle 93 einer Strömungsrichtung C für ein Waschmittel, die sich jeweils durch zwei benachbarte Module der beiden Reihen 210, 220 und in jedem Modul zwischen den Lotpads erstrecken. Damit werden kurze Waschmittelstrecken realisiert, die eine effektive Reinigung des Spalts zwischen elektrischen Moduls 2 und Leiterplatte 1 nach dem Lötprozess erlauben. Wenn die elektrischen Module 2 in den beiden Reihen 210, 220 jeweils um 90° gedreht wären, wäre es dagegen erforderlich, Waschmittelstrecken zu realisieren, die sich jeweils durch eine gesamte Reihe von elektrischen Modulen erstrecken und wesentlich weniger effektiv wären.

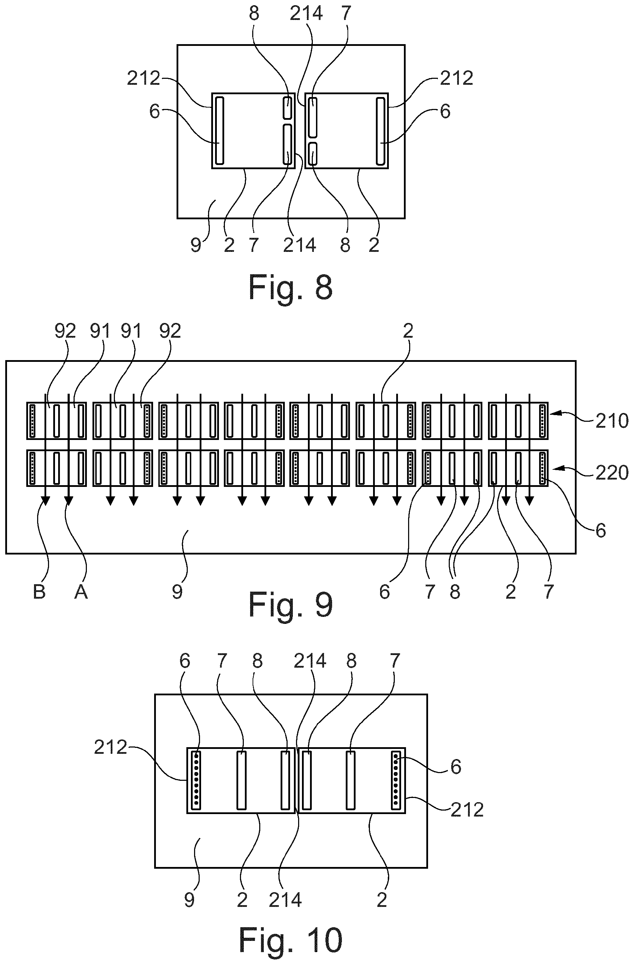

Eine weitere Besonderheit der Anordnung der elektrischen Module 2 in der Figur 7 verdeutlicht die Figur 8, die zwei der Module einer Reihe betrachtet. Danach ist vorgesehen, dass bei zwei betrachteten elektrischen Modulen 2 einer Reihe jeweils das eine dieser elektrischen Module um 180° gedreht zu dem anderen elektrischen Modul 2 angeordnet ist. Hierdurch ergibt sich, dass die Lotpads 7, 8, die einen Source-Kontakt und einen Gate-Kontakt bilden, an einander zugewandten Seitenkanten 214 der beiden Module 2 angeordnet sind. Die Lotpads 6, die jeweils einen Drain-Kontakt bilden, sind da gegen an den einander abgewandten Seitenkanten 212 ausgebildet. Hierdurch wird verhindert, dass ein Lotpad, das mit einem Source-Potential beaufschlagt ist, unmittelbar an ein Lotpad angrenzt, dass mit einem Drain-Potential beaufschlagt ist. Vielmehr wird zwischen diesen Kontakte bei der Anordnung gemäß der Figur 8 auf natürliche Weise eine größtmögliche Luft- und Kriechstrecke realisiert.

Die Figur 9 zeigt eine Leiterplattenanordnung mit einer Mehrzahl von elektrischen Modulen 2, die entsprechend der Anordnung der Figur 7 in zwei Reihen 210, 220 angeordnet sind. Dabei sind die einzelnen elektrischen Module 2 an ihrer Oberseite mit Lotpads versehen, die entsprechend der Ausgestaltung der Figur 1 ausgebildet sind, so dass jeweils ein mittiges Lotpad 7 und zwei sich entlang zweier gegenüberliegender Seitenkanten 212, 214 erstreckende Lotpads 6, 8 vorgesehen sind. Die Ausrichtung der Seitenkanten und Lotpads erfolgt dabei entsprechend der Figur 7, d. h. die Lotpads erstrecken sich jeweils senkrecht zur Längsrichtung der jeweiligen Reihen 210, 220. Damit ergeben sich jeweils zwei parallele Strömungskanäle 91, 92 mit identischen Strömungsrichtungen A, B für ein Waschmittel, die sich jeweils durch zwei benachbarte Module der beiden Reihen 210, 220 und in jedem Modul zwischen den Lotpads erstreckt. Insofern wird auch auf die Ausführungen zur Figur 3 verwiesen. Es werden wiederum kurze Waschmittelstrecken realisiert, die eine effektive Reinigung des Spalts zwischen den elektrischen Modulen 2 und einer Leiterplatte nach dem Lötprozess erlauben.

Aus der Figur 10 ergibt sich, dass ähnlich wie bei der Figur 8 vorgesehen ist, dass bei zwei betrachteten elektrischen Modulen 2 einer Reihe jeweils das eine dieser elektrischen Module um 180° gedreht zu dem anderen elektrischen Modul 2 angeordnet ist. Hierdurch ergibt sich, dass die Lotpads 8, die einen Gate-Kontakt bilden, an einander zugewandten Seitenkanten 214 der beiden Module 2 angeordnet sind. Die Lotpads 6, die jeweils einen Drain-Kontakt bilden, sind da gegen an den einander abgewandten Seitenkanten 212 ausgebildet. Hierdurch wird verhindert, dass ein Lotpad, das mit einem Drain-Potential beaufschlagt ist, unmittelbar an ein Lotpad angrenzt, dass mit einem Gate-Potential beaufschlagt ist. Sofern das Lotpad 8 alternativ mit einem Source-Potential belegt wird (und das Lotpad 7 mit einem Gate-Potential), wird entsprechend der Figur 8 verhindert, dass ein Lotpad, dass mit einem Drain-Potential beaufschlagt ist, unmittelbar an ein Lotpad angrenzt, dass mit einem Source-Potential beaufschlagt ist.

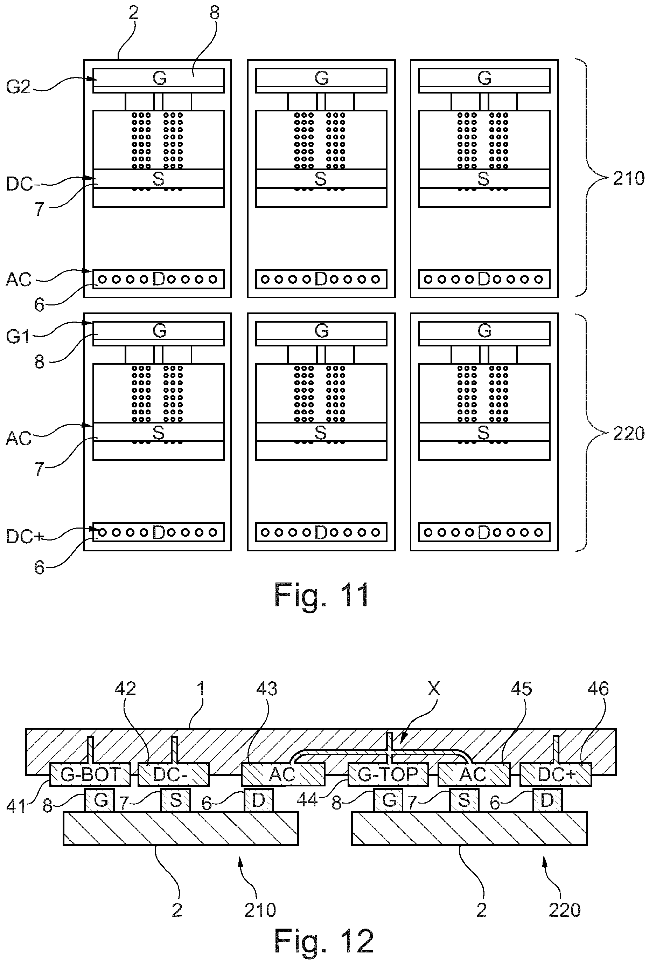

Die Figuren 11 und 12 betrachten zwei Reihen 210, 220 von elektrischen Modulen 2, die einen oberen Schalter und einen unteren Schalter bilden. Die elektrischen Module 2 weisen achsensymmetrisch an der Oberseite ausgebildete Lotpads 6, 7, 8 entsprechend der Ausgestaltung der Figur 1 auf. Dabei sind die elektrischen Module verglichen mit der Anordnung der Figur 9 jeweils um 90° gedreht, so dass ein Drain-Kontakt 6 eines Moduls 2 der oberen Reihe 210 an einen Gate-Kontakt 8 eines Moduls 2 der unteren Reihe 220 unmittelbar angrenzt. Dies führt zu einem Problem, wenn die Schalter zu einer Halbbrückenschaltung verschaltet werden, wie es beispielsweise in einem Wechselrichter erfolgt.

Das diesbezügliche Problem illustriert die Figur 12, die in Schnittansicht - zusammen mit der in der Figur 11 nicht dargestellten Leiterplatte 1 - ein Modul 2 der Reihe 110 und ein Modul 2 der Reihe 220 darstellt. Ein Halbbrückenschaltung sieht vor, dass die Drain-Kontakte 6 der Module der oberen Reihe 210 mit den Source-Kontakten 7 der Modul 2 der unteren Reihe auf das gemeinsame Potential AC gelegt werden. Aufgrund der Lötpadbelegung können diese beiden Kontakte auf der Leiterplatte 1 jedoch nicht direkt kurzgeschlossen werden, da der Gate-Kontakt 8 der Module der unteren Reihe 220 dazwischen liegt. Die entsprechende Überschneidung in der Leiterplatte 1 ist in der Figur 12 schematisch mit X gekennzeichnet. Sie führt zu einer Zerstückelung des AC-Bereichs in der Leiterplatte 1 und damit zu einer Verringerung der Performance P. Insbesondere ist eine Umverdrahtung in der Leiterplatte 1 zur Realisierung der Halbbrückenschaltung erforderlich.

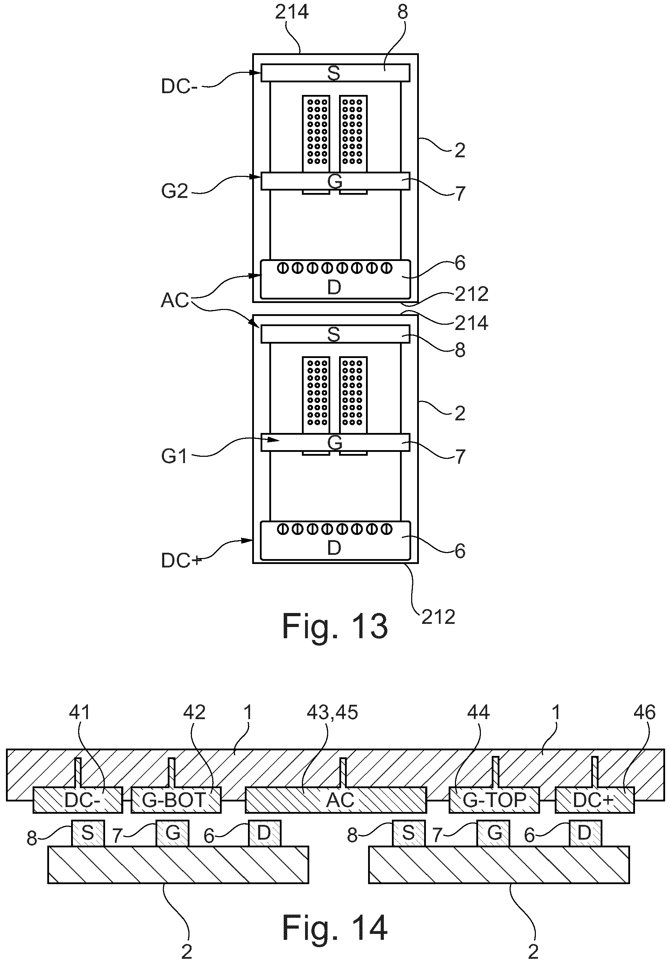

Gemäß der Figuren 13 und 14 wird das Problem dadurch gelöst, dass die Spannungsbeaufschlagung der Lotpads 7, 8 getauscht wird. So wird das Lotpad 7 als Gate-Kontakt ausgeführt und das Lotpad 8 als Source-Kontakt ausgeführt. Dies führt gemäß der Figur 14 dazu, dass die im Rahmen der Halbbrückenschaltung vorzunehmende Kontaktierung zwischen Drain-Kontakt und Source-Kontakt direkt in der Leiterplatte über das Lotpad 43, 45 erfolgen kann, ohne dass Kreuzungen erfolgen.

Einhergehend mit dem Tausch der Spannungsbeaufschlagung der Lotpads 7, 8 werden die in die elektrischen Module 2 eingebetteten elektrischen Bauteile bzw. Halbleiterchips um 180° gedreht angeordnet. Der grundsätzliche Aufbau des elektrischen Moduls beispielsweise entsprechend der Figur 19 bleibt dabei unberührt.

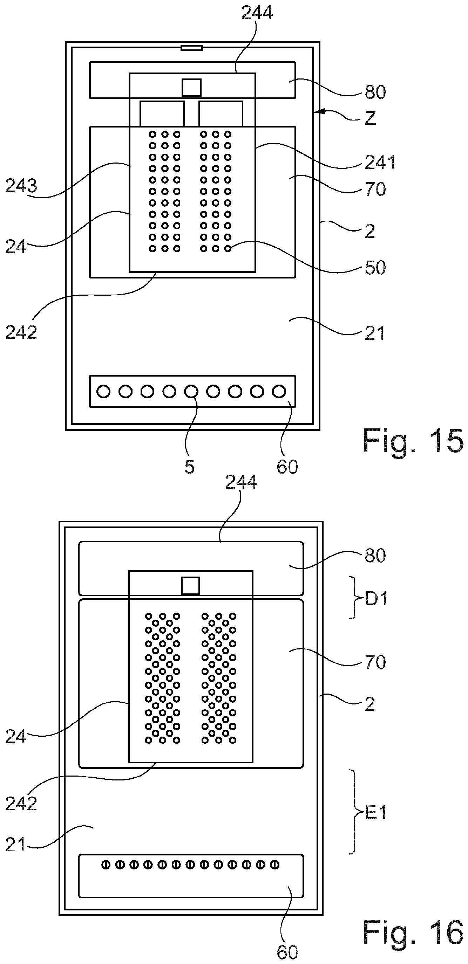

Die Figuren 15-18 zeigen Beispiele elektrischer Module, bei denen Lotpads an der Oberseite des elektrischen Moduls eine Erstreckung derart aufweisen, dass sie die Kanten des eingebetteten elektrischen Bauelementes überdecken und hierdurch lokale Feldstärkenerhöhungen im Spalt zwischen dem elektrischen Modul und der angrenzenden Leiterplatte reduzieren.

Die zugrundeliegende Problematik wird erneut Bezug nehmend auf die Figur 19 erläutert. Das dort dargestellte elektrische Bauelement 24 weist eine linke Seitenkante 243 und eine rechte Seitenkante 244 auf. Im Bereich der linken Seitenkante 243 wird das Bauelement 24 von dem benachbarten Lotpad 7 überdeckt, d. h. das Lotpad 7 ragt über die linke Seitenkante 243 hinaus. An der rechten Seitenkante 244 ist dies nicht der Fall, da das Lotpad 8 vor der rechten Seitenkante 244 des Bauelements 24 endet. Dies führt dazu, dass in dem Spalt 29 zwischen elektrischen Modul 2 und Leiterplatte 1, der mit einem Vergussmaterial gefüllt ist, unterschiedliche Feldstärken auftreten. An der Position P1 existiert im Spalt 29 eine geringere elektrische Feldstärke als im Bereich von P2. Der Grund dafür ist, dass bei P1 das Lotpad 7 bzw. die zugehörige Kontaktfläche die Seitenkante 243 des Bauelements 24 abdeckt und somit das Austreten der Feldlinien direkt oberhalb der Seitenkante 243. Allerdings führt dies zu einer Stauchung der Feldlinien im Bereich P3 über der linken Seitenkante 243, wodurch im Bereich P3 wiederum erhöhte Feldstärken auftreten.

Dabei ist allerdings zu beachten, dass es sich bei dem Material des elektrischen Moduls im Bereich von P3 um ein Leiterplattenmaterial (Prepregmaterial) als Dielektrikum handelt. Dies weist eine relativ hohe Durchschlagsfestigkeit auf und wird in einem stabilen Fertigungsprozess appliziert. Im Vergleich zu dem applizierten Underfillmaterial im Spalt 29 ist das Leiterplattenmaterial daher als robusteres Isolationsmaterial anzusehen. Daher ist die Feldverteilung im linken Bereich P1, P3 trotz der erhöhten Werte im Bereich P3 der Feldverteilung rechten Bereich P2 im Hinblick auf Zuverlässigkeit und Robustheit vorzuziehen.

Auf der Basis dieser Überlegungen erläutern die Figuren 15-18 Maßnahmen, um die Überdeckung der Seitenkanten des elektrischen Moduls zu verbessern.

Die Figur 15 zeigt zunächst ein elektrisches Modul 2, das an seiner Oberseite 21 drei Lotpads 60, 70, 80 ausbildet. Weiter ist schematisch das eingebettete und in der Ansicht von oben an sich nicht erkennbare elektrische Bauelement 24 dargestellt, das in der Ansicht von oben rechteckig ist und dementsprechend vier Seitenkanten 241, 242, 243, 244 aufweist, die nachfolgend auch als Chipkanten bezeichnet werden. Das Lotpad 60 ist beispielsweise mit einem Drain-Kontakt beaufschlagt, das Lotpad 70 ist beispielsweise mit einem Source-Kontakt beaufschlagt und das Lotpad 80 ist beispielsweise mit einem Gate-Kontakt beaufschlagt.

Es ist erkennbar, dass die Lotpads 70, 80 das Bauelement 24 nicht vollständig abdecken. Insbesondere ist ein Bereich Z zwischen den Lotpads 70, 80 nicht abgedeckt und verläuft das Lotpad 70 im Wesentlichen auf der Chipkarte 242, ohne diese substantiell zu überdecken. Hierdurch entstehen die in Bezug auf die Figur 19 erläuterten Probleme.

Die Figur 16 zeigt eine verbesserte Abdeckung des Bauelements 24 in dem Bereich D1, in dem die Lotpads 70, 80 entsprechend vergrößert wurden. Der Bereich E1 bezeichnet eine relativ große Luft- und Kriechstrecke zwischen dem Drain-Kontakt 60 und dem Source-Kontakt 70.

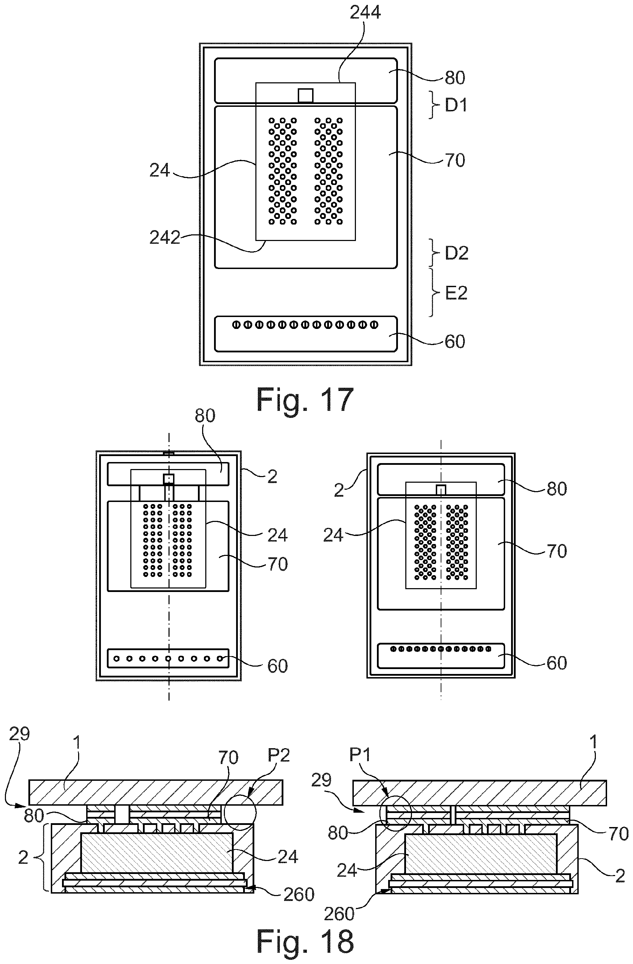

Die Figur 17 zeigt eine weiter verbesserte Abdeckung des Bauelement 24 durch die Lotpads 70, 80. Der Bereich D1 ist ebenso wie in der Figur 16 abgedeckt. Zusätzlich ist das Lotpad 70 vergrößert, so dass es das Bauelement 24 nun auch im Bereich D2 angrenzend an die Chipkante 242 deutlich überdeckt. Der Bereich E2 betreffend eine Luft- und Kriechstrecke zwischen dem Drain-Kontakt 60 und dem Source-Kontakt 70 konnte reduziert werden, da die Feldverteilung im Spalt zwischen dem elektrischen Modul und der Leiterplatte durch die Überdeckung im Bereich D2 verbessert wurde.

Die Figur 18 stellt dieses Ergebnis noch einmal zusammen, wobei links das Modul der Figur 15 und rechts das Modul der Figur 17 dargestellt ist. Weiter sind in jeweiligen Schnittdarstellungen auch die zugehörigen Leiterplatten 1 dargestellt. Beim Modul der Figur 15 (linke Seite der Figur 18) liegt im Bereich P2 des Spalts 29 eine vergleichsweise hohe elektrische Feldstärke vor, was nachteilig ist, da das Underfill-Material im Spalt 29 nicht die Robustheit besitzt, die das Leiterplattenmaterial des elektrischen Moduls besitzt. Beim Modul der Figur 17 (rechte Seite der Figur 18) liegt im Bereich P1 des Spalts 29 eine reduzierte elektrische Feldstärke aufgrund der Überdeckung der Chipkanten durch die Lotpads 70, 80 und die auf diese aufgebrachten Lotschichten vor. Die Gefahr, dass es zu Teilentladungen in Spalt 29 kommt, ist dadurch reduziert.

Der Vollständigkeit halber wird darauf hingewiesen, dass in den beiden Schnittdarstellungen der Figur 18 der Modulbereich mit dem Lotpad 60 nicht dargestellt ist.

Es versteht sich, dass die Erfindung nicht auf die oben beschriebenen Ausführungsformen beschränkt ist und verschiedene Modifikationen und Verbesserungen vorgenommen werden können, ohne von den hier beschriebenen Konzepten abzuweichen. Weiter wird darauf hingewiesen, dass beliebige der beschriebenen Merkmale separat oder in Kombination mit beliebigen anderen Merkmalen eingesetzt werden können, sofern sie sich nicht gegenseitig ausschließen. Die Offenbarung dehnt sich auf alle Kombinationen und Unterkombinationen eines oder mehrerer Merkmale aus, die hier beschrieben werden und umfasst diese. Sofern Bereiche definiert sind, so umfassen diese sämtliche Werte innerhalb dieser Bereiche sowie sämtliche Teilbereiche, die in einen Bereich fallen.

## Patentansprüche

1. Elektrisches Modul, das aufweist:
- eine Oberseite (21) und eine Unterseite (22), wobei die Oberseite (21) vier rechteckig angeordnete Seitenkanten (211-214) aufweist,
- ein in das elektrische Modul (2) eingebettetes elektrisches Bauelement (24),
- mindestens drei an der Oberseite (21) ausgebildete elektrische Lotpads (6, 61-63, 7, 71-74, 8), die einer elektrischen Kontaktierung des elektrischen Bauelements (24) dienen und die dazu ausgebildet und vorgesehen sind, jeweils über eine Lotschicht (16, 17, 18) mit einem zugeordneten elektrischen Lotpad (41, 42, 43) einer Leiterplatte (1) in Kontakt zu treten,
**dadurch gekennzeichnet,**
**dass** die Lotpads (6, 61-63, 7, 71-74, 8) des elektrischen Moduls (2) in symmetrischer Anordnung auf der Oberseite (21) des elektrischen Moduls (2) angeordnet sind, wobei
- die Lotpads (6, 7, 71-72, 8) achsensymmetrisch an der Oberseite (21) des elektrischen Moduls (2) angeordnet sind, und/oder
- sämtliche Lotpads (6, 61-63, 7, 73-74, 8) sich entlang zweier gegenüberliegender Seitenkanten (212, 214) an der Oberseite (21) des elektrischen Moduls (2) erstrecken.

2. Elektrisches Modul nach Anspruch 1, **dadurch gekennzeichnet, dass** die Lotpads (6, 61-63, 7, 71-72, 8) länglich ausgebildet und mindestens zwei der Lotpads (6, 61-63, 7, 71-72, 8) parallel zueinander angeordnet sind.

3. Elektrisches Modul nach Anspruch 1 oder 2, **dadurch gekennzeichnet, dass** drei Lotpads (6, 7, 8) derart achsensymmetrisch an der Oberseite (21) des elektrischen Moduls (2) angeordnet sind, dass ein Lotpad (7) sich entlang einer Mittellinie (95) und die beiden anderen Lotpads (6, 8) sich entlang der der Mittellinie (95) gegenüberliegenden Seitenkanten (212, 214) erstrecken.

4. Elektrisches Modul nach Anspruch 1 oder 2, **dadurch gekennzeichnet, dass** vier Lotpads (6, 71, 72, 8) derart achsensymmetrisch an der Oberseite (21) des elektrischen Moduls (2) angeordnet sind, dass zwei Lotpads (71, 72) sich benachbart zu einer Mittellinie (95) und zwei Lotpads (6, 8) sich entlang der der Mittellinie (95) gegenüberliegenden Seitenkanten (212, 214) erstrecken.

5. Elektrisches Modul nach Anspruch 1, **dadurch gekennzeichnet, dass** sämtliche Lotpads (6, 7, 8) sich derart entlang zweier gegenüberliegender Seitenkanten (212, 214) erstrecken, dass einer der Lotpads (6) an einer Seitenkante (212) und die anderen Lotpads (7, 8) hintereinander entlang der gegenüberliegenden Seitenkante (214) angeordnet sind.

6. Elektrisches Modul nach Anspruch 5, **dadurch gekennzeichnet, dass** die Summe der Flächen der Lotpads (7, 8), die sich an der gegenüberliegenden Seitenkante (214) erstrecken, gleich der Fläche des Lotpads (6) ist, die sich an der einen Seitenkante (212) erstreckt.

7. Elektrisches Modul nach einem der vorangehenden Ansprüche, soweit rückbezogen nach Anspruch 3 oder 4, **dadurch gekennzeichnet, dass**
- die mindestens drei Lotpads (6, 7, 71-72, 8) des elektrischen Moduls (2) mit einem Drain-Potential, einem Source-Potential und einem Gate-Potential beaufschlagt sind, wobei
- das sich entlang der einen Seitenkante (214) erstreckende Lotpad (7) mit einem Source-Potential beaufschlagt ist, und
- das sich entlang der anderen Seitenkante (212) erstreckende Lotpad (6) mit einem Drain-Potential beaufschlagt ist.

8. Elektrisches Modul nach einem der vorangehenden Ansprüche, **dadurch gekennzeichnet, dass** elektrische Modul (2) des Weiteren aufweist:
- einen keramischen Schaltungsträger (260), der eine isolierende Keramikschicht (26) und eine auf der Oberseite der Keramikschicht (26) angeordnete erste Metallisierungsschicht (23) aufweist, wobei das elektrische Bauelement (24) auf der Oberseite der ersten Metallisierungsschicht (23) angeordnet und elektrisch mit dieser verbunden ist,
- wobei die elektrischen Kontakte des Moduls (2) mindestens eine erste Durchkontaktierung (5) umfassen, die sich von einem der Lotpads (6) an der Oberseite (21) bis zu der ersten Metallisierungsschicht (23) erstreckt, sowie zweite und dritte Durchkontaktierungen (50) umfassen, die sich von anderen der Lotpads (7, 8) an der Oberseite (21) zu entsprechenden Kontakten an der Oberseite (242) des elektrischen Bauelements (24) erstrecken.

9. Leiterplattenanordnung, die aufweist:
- eine Leiterplatte (1), die eine Oberseite (11) und eine Unterseite (12) aufweist,
- mindestens ein elektrisches Modul (2) gemäß Anspruch 1, das mit seiner Oberseite (21) an der Unterseite (12) der Leiterplatte (1) angeordnet ist,
- wobei an der Unterseite der Leiterplatte (1) elektrische Lotpads (41-43) ausgebildet sind, die den elektrischen Lotpads (6, 61-63, 7, 71-74, 8) an der Oberseite (21) des elektrischen Moduls (2) zugeordnet sind, wobei die jeweiligen Lotpads über eine Lotschicht (16, 17, 18) elektrisch verbunden sind.

10. Leiterplattenanordnung nach Anspruch 9, **dadurch gekennzeichnet, dass** mehrere elektrische Module (2) vorgesehen und mit der Leiterplatte (1) verbunden sind, wobei
- die elektrischen Module (2) jeweils mindestens drei Lotpads (6, 61-63, 7, 71-74, 8) aufweisen, wobei sich an zwei gegenüberliegenden Seitenkanten (212, 214) jeweils mindestens ein Lotpad (6, 61-63, 7, 71-74, 8) erstreckt,
- die elektrischen Module (2) in zwei Reihen (210, 220) an der Leiterplatte (1) angeordnet und dabei jeweils zwei benachbarte elektrische Module (2) der beiden Reihen (210, 220) derart ausgerichtet sind, dass die mit Lotpads versehenen Seitenkanten (212, 214) miteinander fluchten und sich dabei senkrecht zur Längsrichtung der jeweiligen Reihe (210, 220) erstrecken,
- so dass ein Waschmittelstrom durch jeweils zwei benachbarte elektrischer Module (2) der beiden Reihen (210, 220) in einem Zwischenstadium der Herstellung der Leiterplattenanordnung realisierbar ist, wobei der Waschmittelstrom sich jeweils zwischen der Leiterplatte (1) und der Oberseite (21) des elektrischen Moduls (2) und dabei zwischen den an den gegenüberliegenden Seitenkanten (212, 214) ausgebildeten Lotpads (6, 61-63, 7, 71-74, 8) erstrecken kann.

11. Leiterplattenanordnung nach Anspruch 10, **dadurch gekennzeichnet, dass** die elektrischen Module (2) jeweils drei Lotpads (6, 7, 8) aufweisen, die sich entlang einer Mittellinie (95) und zweier Seitenkanten (212, 214) erstrecken, wobei jeweils zwei benachbarte elektrische Module (2) der beiden Reihen (210, 220) derart ausgerichtet sind, dass auch die beiden sich entlang der Mittellinie (95) erstreckenden Lotpads (7) miteinander fluchten.

12. Leiterplattenanordnung nach Anspruch 10 oder 11, **dadurch gekennzeichnet, dass**
- die mindestens drei Lotpads (6, 7, 8) jedes elektrischen Moduls (2) mit einem Source-Potential, einem Drain-Potential und einem Gate-Potential beaufschlagt sind, und
- zwei benachbarte elektrische Module (2) einer Reihe (210, 220) jeweils derart ausgerichtet sind, dass ein an einer Seitenkante (214) angeordnetes Lotpad des einen elektrischen Moduls (2), das mit einem Source-Potential beaufschlagt ist, nicht an ein Lotpad an der benachbarten Seitenkante (212) des benachbarten elektrischen Moduls (2), das mit einem Drain-Potential beaufschlagt ist, angrenzt.

13. Leiterplattenanordnung nach Anspruch 12, **dadurch gekennzeichnet, dass** für zwei benachbarte elektrische Module (2) einer Reihe (210, 220) jeweils gilt, dass das eine elektrische Modul relativ zu dem anderen elektrischen Modul um 180° gedreht angeordnet ist.

14. Leiterplattenanordnung nach einem der vorangehenden Ansprüche, soweit rückbezogen auf Anspruch 10, **dadurch gekennzeichnet, dass** die in einer Reihe (210, 220) angeordneten elektrischen Module (2) jeweils einen logischen Schalter bilden.

15. Leiterplattenanordnung nach Anspruch 14, **dadurch gekennzeichnet, dass** die Schalter über eine entsprechende Verdrahtung in der Leiterplatte (1) zu einer Halbbrückenschaltung zusammengeschaltet sind, in der der Drain-Kontakt (6) des einen Schalters und der Source-Kontakt (8) des anderen Schalters auf demselben Potential liegen.
